# FASCICULE DE BREVET EUROPEEN

(11) **EP 3 435 398 B1**
(45) Date de publication et mention de la délivrance du brevet: **09.10.2019**
(21) Numéro de dépôt: 18173347.8
(22) Date de dépôt: 18.05.2018
(51) Int. Cl.: H01H 83/14

(54) **APPAREIL DE PROTECTION ÉLECTRIQUE DIFFERENTIELLE**
ELEKTRISCHES DIFFERENTIALSCHUTZGERÄT
DIFFERENTIAL ELECTRICAL PROTECTION APPARATUS

(30) Priorité: 25.07.2017 FR 1757064
(43) Date de publication de la demande: 30.01.2019
(73) Titulaire: Schneider Electric Industries SAS, 92500 Rueil-Malmaison (FR); Fuji Electric FA Components & Systems Co. Ltd., Tokyo 103-0011 (JP)
(72) Inventeur: NEREAU, Jean-Pierre, 38050 GRENOBLE (FR); SATO, Yutaka, 38050 GRENOBLE (FR); HASHIMOTO, Takashi, 38050 GRENOBLE (FR); HOSOOKA, Yohei, 38050 GRENOBLE (FR)
(74) Mandataire: Colette, Marie-Françoise

(56) Documents cités:
- EP-A1- 1 736 784
- EP-A2- 0 903 765
- DE-U1- 29 724 317

## Description

### DOMAINE TECHNIQUE

La présente invention concerne les disjoncteurs différentiels, et spécifiquement les disjoncteurs dans lesquels la fonction différentielle est intégrée à la fonction de protection contre les courts circuits, en particulier les disjoncteurs comportant une unité de déclenchement électronique.

### ETAT DE LA TECHNIQUE ANTERIEURE

On connaît des appareils de protection électrique différentielle destinés à la protection d'au moins N lignes électriques et comportant un dispositif de coupure et un module de déclenchement, ce dernier étant destiné à être connecté au dispositif de coupure, ledit module de déclenchement comportant d'une part, un dispositif de mesure du courant différentiel dans au moins deux lignes de courant, ce dispositif de mesure du courant différentiel comportant un circuit magnétique destiné à entourer des conducteurs dits primaires associés respectivement aux lignes de courant précitées, formant un circuit primaire d'un transformateur, et un enroulement secondaire enroulé autour du circuit magnétique et formant le circuit secondaire du transformateur, et d'autre part, des capteurs de mesure du courant respectivement pour chaque ligne de courant, ledit dispositif de coupure comportant des moyens d'alimentation, des moyens de traitement reliés électriquement en amont, au dispositif de mesure du courant différentiel et aux différents capteurs de mesure du courant, et en aval, à un dispositif d'actionnement d'un mécanisme d'ouverture des contacts.

La principale difficulté qui doit être résolue, pour loger la fonction de protection différentielle à l'intérieur de l'unité électronique, est le manque de place pour loger le tore de mesure qui est absolument nécessaire pour réaliser la fonction de protection différentielle. Un exemple d'appareil de protection électrique différentielle est décrit dans EP-A-0903765.

Il est connu du brevet EP 1045500 que l'un des capteurs de phase, utilisé pour la protection contre les court-circuits, puisse être retiré pour placer le tore. Il est également connu qu'un tel tore puisse être accompagné d'un transformateur de courant entourant les trois ou quatre conducteurs primaires, pour apporter de la puissance à l'unité de traitement dans le cas où le conducteur primaire non muni de capteur de phase présenterait un défaut à la terre.

Or, retirer un tel capteur de phase est possible s'il peut être assuré que la somme des courants dans les conducteurs primaires est égale à zéro. Dans ce cas, le courant en provenance du capteur manquant peut être considéré comme étant égal à la somme des courants provenant des autres capteurs.

Mais cette supposition n'est vraie que si la fonction différentielle assure le déclenchement du disjoncteur suffisamment vite pour procurer une réponse adéquate en cas de court-circuit. Or, il est d'usage que le déclenchement de la protection différentielle puisse être temporisé, au choix de l'utilisateur, d'une seconde ou plus.

En outre, il y a des variantes de tels disjoncteurs différentiels dans lesquelles la fonction différentielle est utilisée seulement pour donner l'alarme, et ne conduit pas le disjoncteur à déclencher réellement.

### EXPOSE DE L'INVENTION

La présente invention résout ces problèmes et propose un appareil de protection électrique différentielle permettant de mesurer réellement le courant de tous les conducteurs primaires, sans réduire l'espace disponible pour le tore.

A cet effet, la présente invention a pour objet un appareil de protection électrique différentielle du genre précédemment mentionné, cet appareil étant caractérisé en ce qu'il comporte N-1 conducteurs de phases, chaque conducteur de phase comportant entre une plage de raccordement dite d'entrée, ou supérieure, et une plage de raccordement dite de sortie, ou inférieure, une portion apte à traverser le tore précité et une portion apte à traverser un capteur de mesure et d'alimentation du courant, les plages de raccordement dites d'entrée étant situées dans un plan dit premier, et les plages de raccordement dites de sortie s'étendant dans un plan dit second, en ce que les capteurs d'alimentation et de mesure précités des N-1 conducteurs de phase sont placés chacun dans l'espace situé entre les deux plans précités, et en ce que l'appareil comporte en outre un conducteur de phase, dit additionnel, comportant une plage de raccordement dite d'entrée et une plage de raccordement dite de sortie, une portion apte à traverser le tore précité et une portion apte à traverser un capteur de mesure ne réalisant que la mesure du courant, dit additionnel, ce capteur de mesure dit additionnel étant de petite taille et étant placé directement au-dessus du tore, de manière que l'ensemble constitué par le tore et le capteur additionnel soit situé sensiblement dans l'espace compris entre les deux plans précités.

Selon une caractéristique particulière, le capteur de mesure précité est un capteur de type Rogowski.

Selon une autre caractéristique, le tore précité est associé à un transformateur de courant entourant les conducteurs de phase, de manière à fournir de la puissance aux moyens de traitement en présence d'un défaut à la terre sur le conducteur de phase dit additionnel.

Selon une caractéristique particulière, chaque conducteur principal de phase comporte une partie principale dite première destinée à traverser le tore et, à chacune de ses deux extrémités, une portion de raccordement s'étendant sensiblement perpendiculairement à la partie principale, les deux portions de raccordement de chaque conducteur de phase s'étendant respectivement suivant deux directions opposées.

Selon une réalisation particulière, le capteur de mesure dit additionnel est conformé de telle manière que son axe s'étende sensiblement parallèlement à l'axe du tore.

Selon une autre réalisation, le conducteur de phase dit additionnel est conformé de telle manière que son axe s'étende sensiblement perpendiculairement à l'axe du tore.

Selon une autre caractéristique, les deux plages de raccordement d'un même conducteur de phase s'étendent sensiblement parallèlement l'une par rapport à l'autre.

Selon une autre caractéristique, le ou chacun des N-1 conducteurs de phase a subi une première fois deux pliages à angle droit de manière à permettre son introduction dans l'ouverture du tore, après quoi ledit conducteur a été plié de nouveau deux fois à angle droit de manière à être introduit dans le capteur de mesure et d'alimentation associé audit conducteur, tandis que le conducteur de phase additionnel traverse successivement et directement le tore puis le capteur de mesure additionnel sans pliage.

Selon une réalisation particulière, N est égale à trois, l'appareil étant du type tripolaire.

Selon une autre réalisation, N est égale à quatre, l'appareil étant du type tétrapolaire.

Selon une caractéristique particulière, cet appareil est un disjoncteur.

Mais d'autres avantages et caractéristiques de l'invention apparaîtront mieux dans la description détaillée qui suit et se réfère aux dessins annexés donnés uniquement à titre d'exemple et dans lesquels :
- Les figures 1 à 7 illustrent une première réalisation de l'invention,
- La figure 1 est une vue en perspective illustrant un appareil de protection électrique différentiel selon l'invention sans le capteur de la phase centrale,
- La figure 2 est une vue en perspective illustrant un appareil de protection électrique différentiel selon l'invention avec le capteur de la phase centrale,
- La figure 3 est une vue en coupe selon un plan P de la figure 2,
- La figure 4 est une représentation schématique, illustrant les différents éléments composant l'appareil de protection électrique différentiel selon l'invention, et leur agencement les uns par rapport aux autres,
- La figure 5 est une vue en perspective illustrant les conducteurs primaires sans les capteurs,
- La figure 6 est une vue en perspective illustrant les conducteurs primaires avec le capteur sommateur dit tore,
- La figure 7 est une vue en perspective illustrant les conducteurs primaires avec le capteur sommateur et le capteur phase centrale,
- Les figures 8 à 11 illustrent une seconde réalisation de l'invention,

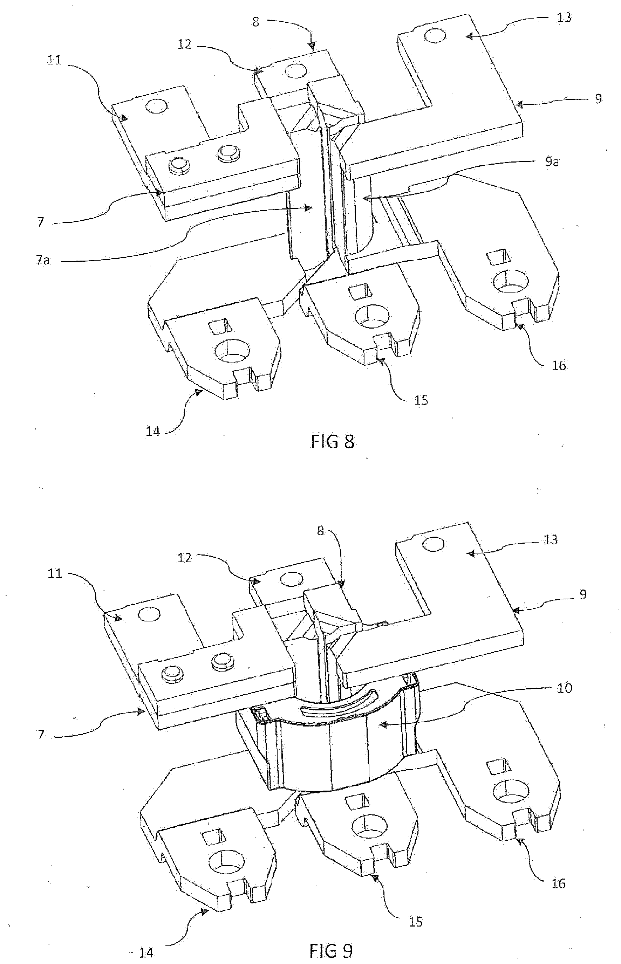

- La figure 8 est une vue en perspective, illustrant les conducteurs primaires sans les capteurs de phase et sans le capteur sommateur,
- La figure 9 est une vue en perspective illustrant les conducteurs primaires sans les capteurs de phase et avec le capteur sommateur,

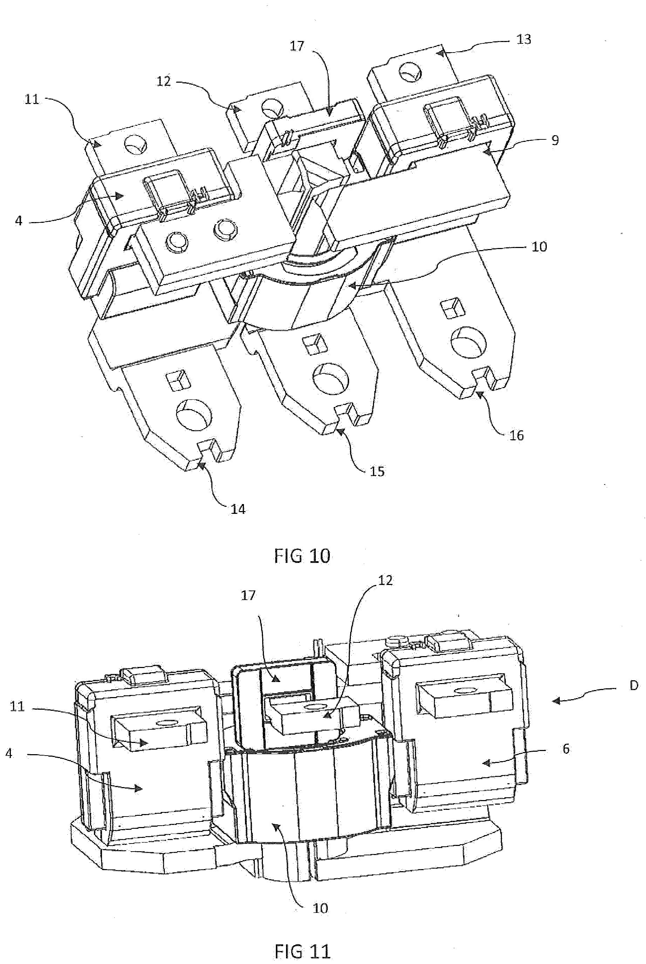

- La figure 10 est une vue en perspective illustrant les conducteurs primaires avec les capteurs de phase et le capteur sommateur, et
- La figure 11 est une vue en perspective du même ensemble que sur la figure précédente, mais vu de l'autre côté,

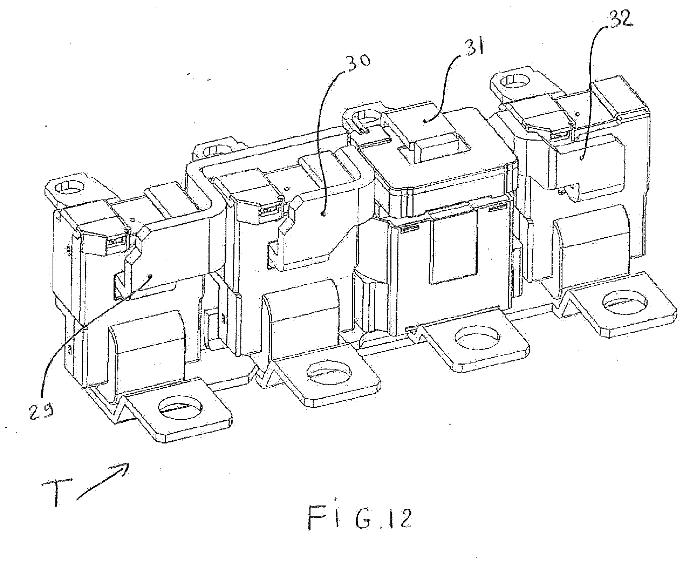

- La figure 12 est une vue en perspective illustrant en partie la partie intérieure d'un disjoncteur tétra polaire différentiel selon l'invention,

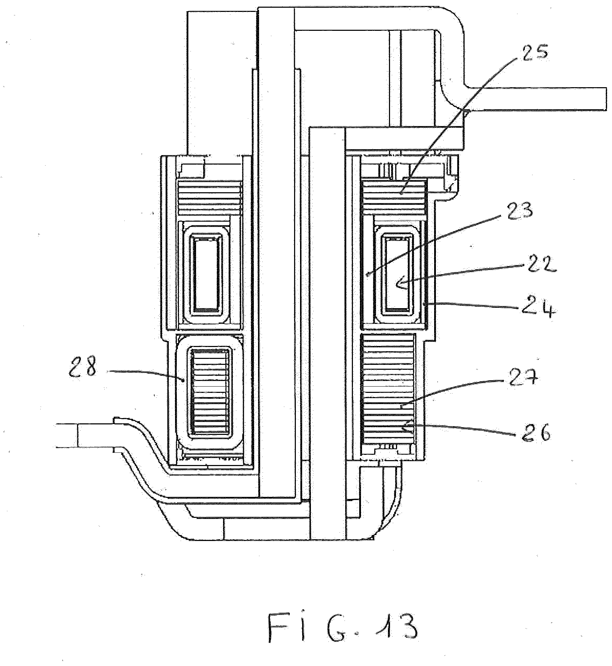

- La figure 13 est une vue en coupe axiale du sommateur et de son capteur d'alimentation associé, selon l'invention,

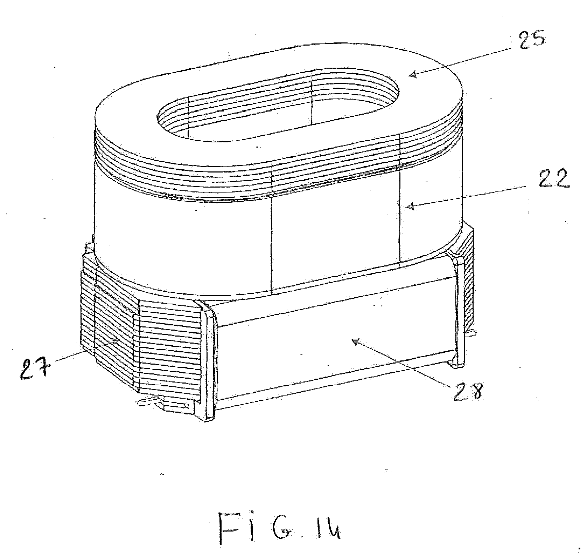

- La figure 14 est une vue en perspective de ce même ensemble, et

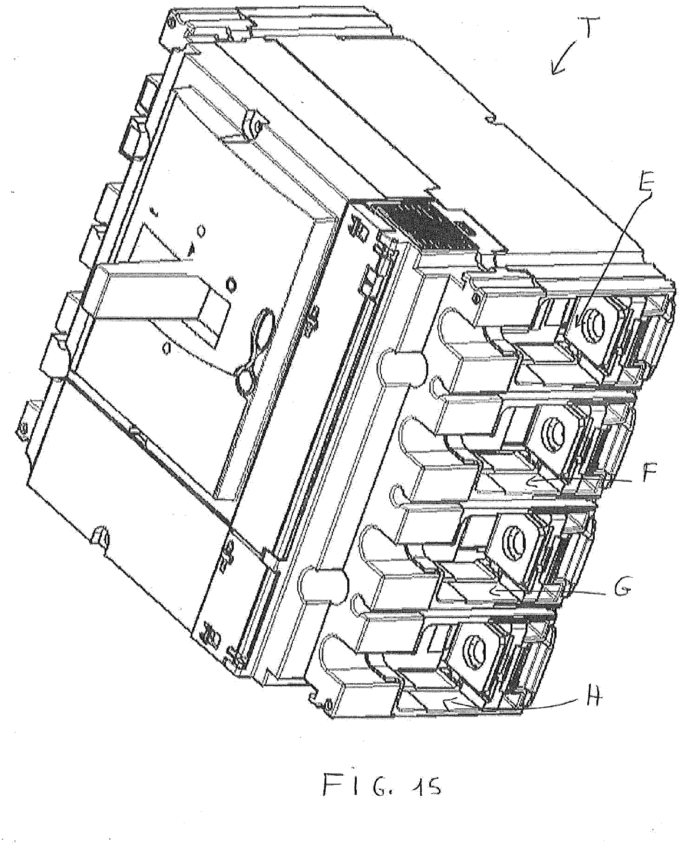

- La figure 15 est une vue en perspective illustrant le disjoncteur tétra polaire différentiel précité dans sa totalité.

Sur les figures, on voit un appareil de protection électrique différentiel D destiné à la protection électrique de trois lignes électriques 1,2,3 et comportant principalement de manière connue en soi un dispositif de coupure et un module de déclenchement destiné à être connecté au dispositif de coupure. Ce module de déclenchement comporte d'une part, un dispositif de mesure du courant différentiel dans au moins deux lignes de courant, et des capteurs de mesure du courant et d'alimentation associés respectivement à chaque ligne de courant. Tel qu'illustré sur les figures, chaque capteur de mesure et d'alimentation 4,6 est monté autour d'un conducteur de phase 7,9, associé à ladite ligne de courant.
Ce dispositif de mesure du courant différentiel comporte un circuit magnétique 10 destiné à entourer les conducteurs primaires associés respectivement aux lignes de courant précitées, ce circuit magnétique formant le circuit primaire d'un transformateur, et un enroulement secondaire enroulé autour du circuit magnétique et formant le circuit secondaire du transformateur.

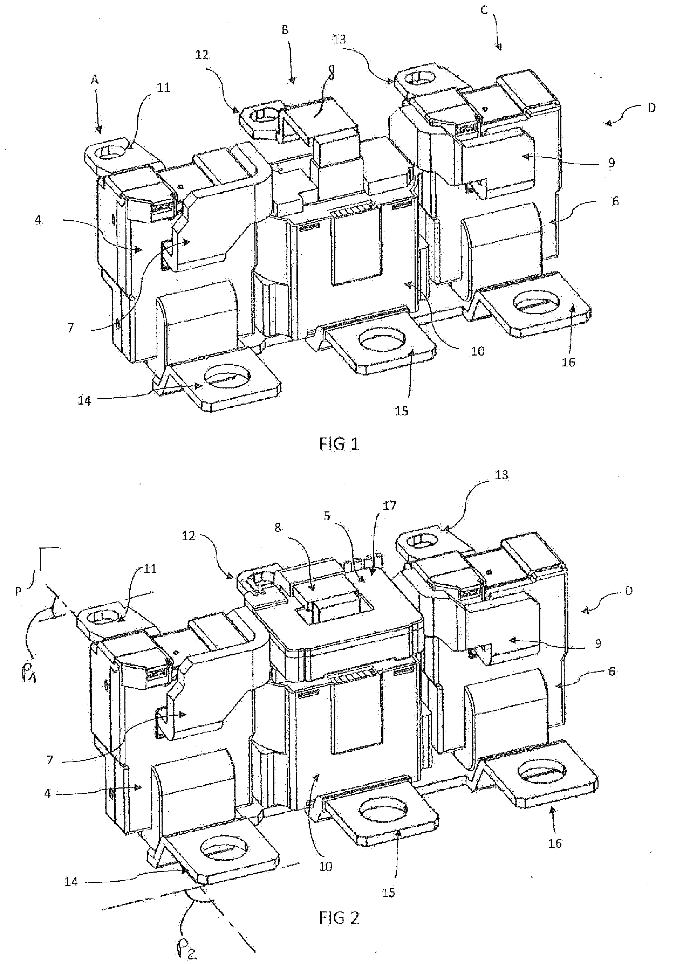

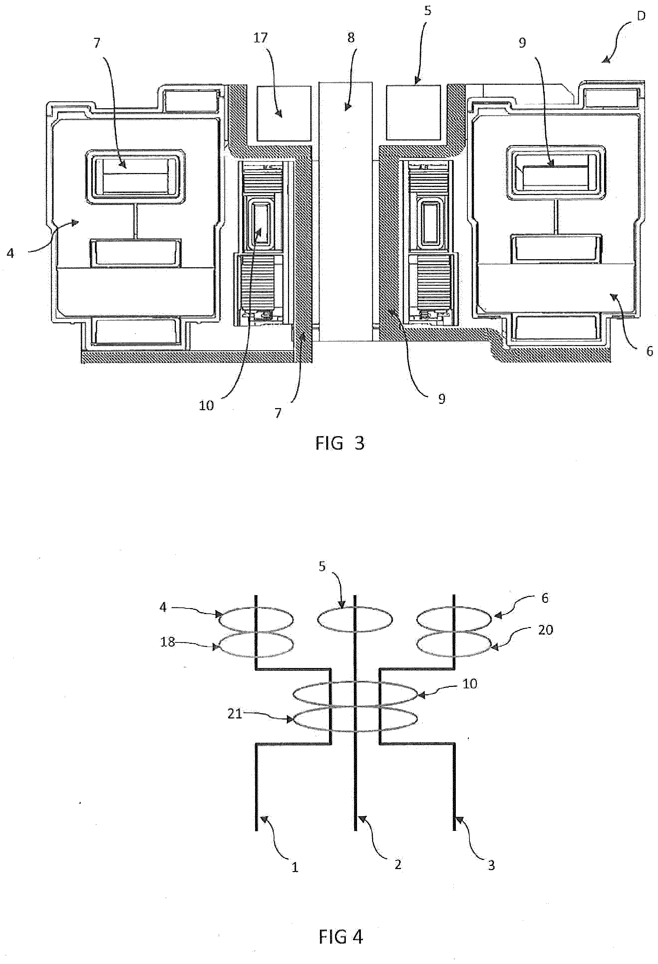

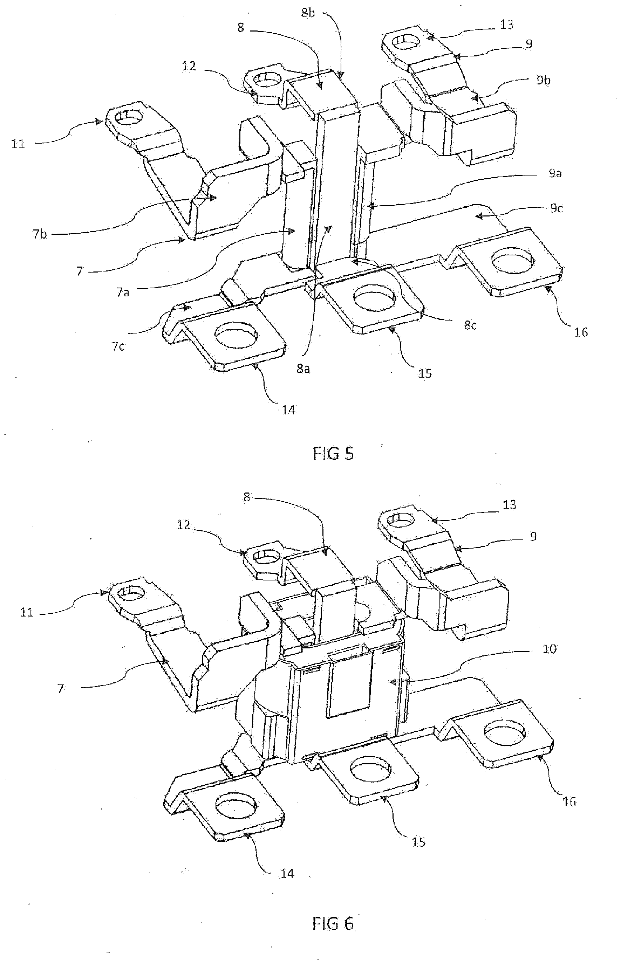

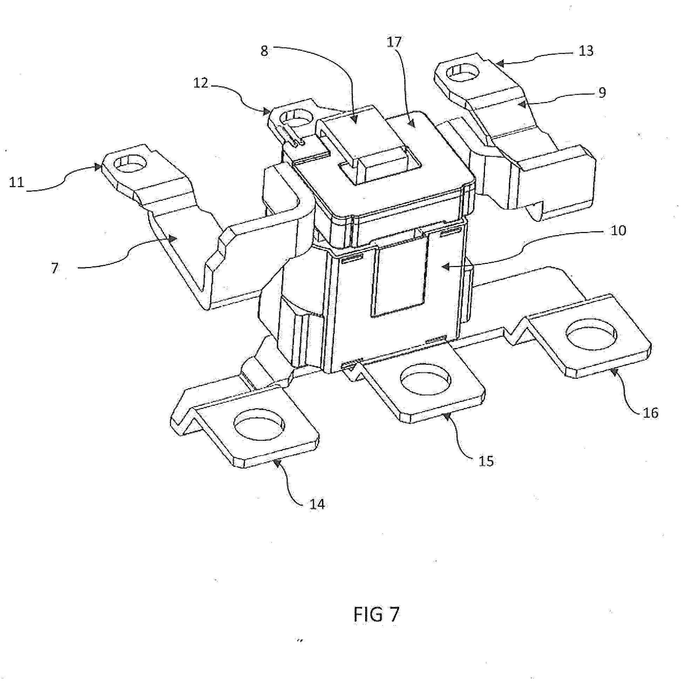

Ce dispositif de coupure comporte des moyens d'alimentation, des moyens de traitement reliés électriquement en amont, au dispositif de mesure du courant différentiel et aux différents capteurs de mesure du courant et d'alimentation, et en aval, à un dispositif d'actionnement d'un mécanisme d'ouverture des contacts.
Tel qu'illustré sur les figures 1,2, chaque appareil de protection électrique différentiel D comporte trois parties A, B, C correspondant respectivement aux différentes phases de l'appareil.
Chaque conducteur de phase 7, 8, 9 comporte une partie principale 7a, 8a, 9a comportant à chacune de ses deux extrémités opposées, une partie de raccordement 7b,7c,8b,8c,9b,9c s'étendant sensiblement perpendiculairement à la partie principale, mais suivant deux directions opposées pour ces deux portions.
Ces parties de raccordement comportent à leurs extrémités libres, des plages de raccordement dites d'entrée 11,12,13, et des plages de raccordement dites de sortie 14,15,16. Les plages de raccordement dites d'entrée 11,12,13 sont disposées dans un plan dit premier P1, tandis que les plages de raccordement dites de sortie 14,15,16 sont disposées dans un plan dit second P2.
Les trois conducteurs de phase sont disposés côte à côte de manière que leurs parties principales soient réunies de manière à permettre leur passage à travers l'ouverture du tore 10 du transformateur.
Selon l'invention, chacun des deux conducteurs de phase d'extrémité 7,9 supporte un capteur de mesure et d'alimentation 4,6 monté autour de l'une 7b, 9b des parties de raccordement précitées, les deux parties supportant ces capteurs étant situées du même côté de l'appareil.
Pour chaque conducteur de phase d'extrémité 7,9, le capteur de mesure et d'alimentation est logé dans l'espace compris sensiblement entre les deux plans P1,P2.
Dans le but d'optimiser l'espace à l'intérieur de l'appareil de protection électrique, la partie située entre les deux plans précités P1,P2 au niveau du conducteur central, est destinée à loger le tore 10 du circuit magnétique, et ne peut donc pas recevoir un capteur de mesure du type de celui utilisé pour les deux conducteurs d'extrémité 7,9. Pour ces deux conducteurs d'extrémité 7,9 en effet, les capteurs de mesure sont des capteurs dits de mesure et d'alimentation, car ils peuvent aussi être connectés aux moyens d'alimentation précités afin d'assurer l'alimentation des moyens de traitement. Ainsi, grâce à ce type de capteurs, l'alimentation électrique des moyens de traitement associés au dispositif de mesure différentiel peut être réalisée sans alimentation électrique auxiliaire. On notera que les fonctions de mesure et d'alimentation peuvent être réalisées par un capteur réalisant la mesure et un autre capteur réalisant l'alimentation 18,19.
Conformément à l'invention, afin de permettre à la fois la mesure du courant circulant dans le conducteur principal central 8, et le logement du tore 10, l'on place un capteur de mesure du courant simple, dit additionnel 17, c'est-à-dire ne pouvant pas réaliser la fonction d'alimentation électrique précitée, autour d'une partie de raccordement 8b du conducteur principal central 8, ce capteur de mesure 17 additionnel étant disposé au-dessus du tore 10. Le conducteur central 8 est conformé par un pliage approprié de la matière dont il est constitué, de telle manière que l'ensemble formé par le tore 10 et le capteur de mesure additionnel central 17 soit situé sensiblement dans l'espace compris entre les deux plans précités.
Selon la première réalisation illustrée sur les figures 1 à 7, l'on voit que le capteur de mesure central dit additionnel 17 est disposé de telle manière que son axe soit parallèle et avantageusement même confondu avec l'axe du tore 10 du circuit magnétique. Selon la seconde réalisation illustrée sur les figures 8 à 11, ce capteur de phase central 17 est disposé de telle manière que son axe s'étende sensiblement perpendiculairement à l'axe du tore 10.
Selon l'invention, le courant circulant dans la ligne dépourvue habituellement de capteur, est mesuré en utilisant un capteur additionnel de petite taille, de préférence de type Rogowski, de mesure uniquement, et placé au-dessus du tore.
Tel que plus particulièrement illustré sur la figure 4, selon l'invention, tous les conducteurs primaires traversent le tore. Seul le conducteur du pôle central traverse directement le capteur additionnel sans pliage, tandis que les autres conducteurs sont courbés de manière à s'éloigner du capteur additionnel et à être dirigés vers leurs positions de pôle respectives.

Sur la figure 4, l'on voit également que les plages de raccordement 11,12,13 des conducteurs 7,8,9 situées d'un côté du tore, sont espacées les unes par rapport aux autres d'un espace correspondant à celui séparant les plages de raccordement 14,15,16 des conducteurs 7,8,9 situées du côté du tore opposé au précédent. Entre les plages de raccordement 11,13 situées à la partie dite inférieure du tore 10 et celles 14,16 situées à la partie supérieure du tore, les conducteurs d'extrémité 7,9 sont pliés deux fois à 90°, de manière à pouvoir traverser le tore de mesure, puis de nouveau deux fois à angle droit de manière à traverser un capteur d'alimentation et de mesure 4,6, tandis que le conducteur central 8 traverse directement le tore 10 puis le capteur de mesure dit central 5 sans pliage.
En utilisant un capteur du type Rogowski, la taille du capteur additionnel est très réduite, lui permettant de s'adapter à l'espace très limité disponible, et le courant peut être mesuré jusqu'à des niveaux de courants de court-circuit. Dans les réalisations illustrées sur les figures 8 à 11, ce capteur additionnel est placé au niveau de la partie dite supérieure du tore.
Selon une autre réalisation non illustrée, ce capteur pourra être situé au niveau de la partie inférieure du tore, c'est-à-dire du côté des plages de raccordement 14,15,16 opposées à celles 11,12,13 situées à la partie supérieure du tore 10.
Tel qu'illustré sur les figures 13 et 14, le tore sommateur 22 présente un blindage extérieur 24, un blindage intérieur 23, et un blindage supérieur 25.
Cet ensemble est placé au-dessus d'un tore d'alimentation 26 comportant une bobine 28 et un circuit magnétique 27 servant également de blindage inférieur.
On notera qu'avantageusement le tore précité 10 peut être associé à un transformateur de courant 21 entourant les conducteurs de phase, de manière à fournir de la puissance aux moyens de traitement en présence d'un défaut à la terre sur le conducteur de phase additionnel.
Bien que les figures 1 à 11 illustrent un dispositif de protection différentiel de type tripolaire, l'invention peut également être appliquée dans un disjoncteur de type tétra polaire tel qu'illustré sur la figure 12 comportant quatre modules E ,F,G ,H, et dans lequel le sommateur est traversé par quatre conducteurs de phase 29 à 32.

On a donc réalisé grâce à l'invention un appareil de protection électrique différentiel de conception simple permettant de mesurer réellement le courant dans tous les conducteurs primaires, sans pour cela réduire l'espace disponible pour le tore.

Bien entendu, l'invention n'est pas limitée aux modes de réalisations décrits et illustrés qui n'ont été donnés qu'à titre d'exemple.
Au contraire, l'invention comprend tous les équivalents techniques des moyens décrits ainsi que leurs combinaisons si celles-ci sont réalisées suivant son esprit.

## Revendications

1. Appareil de protection électrique différentielle destiné à la protection d'au moins N lignes électriques et comportant un dispositif de coupure et un module de déclenchement destiné à être connecté au dispositif de coupure, ledit module de déclenchement comportant d'une part, un dispositif de mesure du courant différentiel dans au moins deux lignes de courant, ce dispositif de mesure du courant différentiel comportant un circuit magnétique comportant un tore destiné à entourer des conducteurs dits primaires associés respectivement aux lignes de courant précitées, et d'autre part des capteurs de mesure du courant et d'alimentation respectivement pour chaque ligne de courant, ledit dispositif de coupure comportant des moyens d'alimentation et des moyens de traitement reliés électriquement en amont, au dispositif de mesure du courant différentiel et aux différents capteurs de mesure du courant et d'alimentation, et en aval, à un dispositif d'actionnement d'un mécanisme d'ouverture des contacts, **caractérisé en ce qu'**il comporte N-1 conducteurs de phases (7,9), chaque conducteur de phase comportant entre une plage de raccordement dite d'entrée, ou supérieure (11,13), et une plage de raccordement dite de sortie, ou inférieure (14,16), une portion (7a,9a) apte à traverser le tore précité (10) et une portion (7b,9b) apte à traverser un capteur de mesure et d'alimentation du courant (4,6), les plages de raccordement dites d'entrée (11,13) étant situées dans un premier plan (P1), et les plages de raccordement dites de sortie (14,16) s'étendant dans un second plan (P2) **en ce que** les capteurs d'alimentation et de mesure (4,6) précités des N-1 conducteurs de phase sont placés chacun dans l'espace situé entre les deux plans (P1, P2), et **en ce que** l'appareil comporte en outre un conducteur de phase (8), dit additionnel, comportant une plage de raccordement dite d'entrée (12) et une plage de raccordement dite de sortie (15), une portion (8a) apte à traverser le tore précité et une portion (8b) apte à traverser un capteur de mesure ne réalisant que la mesure du courant, dit additionnel (17), ce capteur de mesure dit additionnel (17) étant de petite taille et étant placé directement au-dessus du tore (10), de manière que l'ensemble constitué par le tore (10) et le capteur additionnel (17) soit situé sensiblement dans l'espace compris entre les deux plans (P1, P2).

2. Appareil selon la revendication 1, **caractérisé en ce que** le capteur de mesure précité (17) est un capteur de type Rogowski.

3. Appareil selon la revendication 1 ou 2, **caractérisé en ce que** le tore précité (10) est associé à un transformateur de courant (21) entourant les conducteurs de phase (7, 8, 9), de manière à fournir de la puissance aux moyens de traitement en présence d'un défaut à la terre sur le conducteur de phase dit additionnel (8).

4. Appareil selon l'une quelconque des revendications précédentes, **caractérisé en ce que** chaque conducteur de phase (7, 8, 9) comporte une partie principale dite première (7a,8a,9a) destinée à traverser le tore (10) et, à chacune de ses deux extrémités, une portion de raccordement (7b,7c,8b,8c,9b,9c) s'étendant sensiblement perpendiculairement à la partie principale (7a,8a,9a), les deux portions de raccordement de chaque conducteur de phase s'étendant respectivement suivant deux directions opposées.

5. Appareil selon l'une quelconque des revendications précédentes, **caractérisé en ce que** le capteur de mesure dit additionnel (17) est conformé de telle manière que son axe s'étende sensiblement parallèlement à l'axe du tore (10).

6. Appareil selon l'une quelconque des revendications 1 à 4, **caractérisé en ce que** le capteur de phase dit additionnel (17) est conformé de telle manière que son axe s'étende sensiblement perpendiculairement à l'axe du tore (10).

7. Appareil selon l'une quelconque des revendications précédentes, **caractérisé en ce que** les deux plages de raccordement d'entrée (11, 12, 13) et de sortie (14, 15, 16) d'un même conducteur de phase (7, 8, 9) s'étendent sensiblement parallèlement l'une par rapport à l'autre.

8. Appareil selon l'une quelconque des revendications précédentes, **caractérisé en ce que** le ou chacun des N-1 conducteurs de phase (7, 8, 9) a subi une première fois deux pliages à angle droit de manière à permettre son introduction dans l'ouverture du tore (10), après quoi ledit conducteur a été plié de nouveau deux fois à angle droit de manière à être introduit dans le capteur de mesure et d'alimentation (4,6) associé audit conducteur, tandis que le conducteur de phase additionnel (8) traverse successivement et directement le tore (10) puis le capteur de mesure additionnel (17) sans pliage.

9. Appareil selon l'une quelconque des revendications précédentes, **caractérisé en ce que** N est égale à trois, l'appareil étant du type tripolaire.

10. Appareil selon l'une quelconque des revendications 1 à 8, **caractérisé en ce que** N est égale à quatre, l'appareil étant du type tétrapolaire.

11. Appareil selon l'une quelconque des revendications précédentes, **caractérisé en ce que** c'est un disjoncteur.

## Patentansprüche

1. Elektrisches Differentialschutzgerät, welches zum Schutz von wenigstens N elektrischen Leitungen bestimmt ist und ein Schaltgerät und ein Auslösemodul, das dazu bestimmt ist, mit dem Schaltgerät verbunden zu werden, umfasst, wobei das Auslösemodul einerseits eine Vorrichtung zur Messung des Differenzstroms in wenigstens zwei Stromleitungen umfasst, wobei diese Vorrichtung zur Messung des Differenzstroms einen Magnetkreis umfasst, der ein Toroid umfasst, das dazu bestimmt ist, sogenannte Primärleiter zu umgeben, die den oben erwähnten Stromleitungen zugeordnet sind, und andererseits Sensoren zur Messung des Stroms und zur Stromzuführung jeweils für jede Stromleitung, wobei das Schaltgerät Stromzuführungsmittel und Verarbeitungsmittel umfasst, die auf der Einspeiseseite mit der Vorrichtung zur Messung des Differenzstroms und den verschiedenen Sensoren zur Messung des Stroms und zur Stromzuführung und auf der Abgangsseite mit einer Vorrichtung zur Betätigung eines Mechanismus zur Öffnung der Kontakte elektrisch verbunden sind,
**dadurch gekennzeichnet, dass** es N-1 Phasenleiter (7, 9) umfasst, wobei jeder Phasenleiter zwischen einem sogenannten Eingangs- oder oberen Anschlussbereich (11, 13) und einem sogenannten Ausgangs- oder unteren Anschlussbereich (14, 16) einen Abschnitt (7a, 9a), der geeignet ist, das oben erwähnte Toroid (10) zu durchqueren, und einen Abschnitt (7b, 9b), der geeignet ist, einen Sensor zur Messung und Zuführung des Stroms (4, 6) zu durchqueren, aufweist, wobei sich die sogenannten Eingangs-Anschlussbereiche (11, 13) in einer ersten Ebene (P1) befinden und sich die sogenannten Ausgangs-Anschlussbereiche (14, 16) in einer zweiten Ebene (P2) erstrecken,
dadurch, dass die oben erwähnten Sensoren zur Stromzuführung und Messung (4, 6) der N-1 Phasenleiter jeweils in einem Raum angeordnet sind, der sich zwischen den zwei Ebenen (P1, P2) befindet,
und dadurch, dass das Gerät außerdem einen sogenannten zusätzlichen Phasenleiter (8) umfasst, der einen sogenannten Eingangs-Anschlussbereich (12) und einen sogenannten Ausgangs-Anschlussbereich (15), einen Abschnitt (8a), der geeignet ist, das oben erwähnte Toroid zu durchqueren, und einen Abschnitt (8b), der geeignet ist, einen nur die Messung des Stroms durchführenden, sogenannten zusätzlichen Messer (17) zu durchqueren, aufweist, wobei dieser sogenannte zusätzliche Messer (17) von geringer Größe ist und direkt oberhalb des Toroids (10) angeordnet ist, so dass sich die aus dem Toroid (10) und dem zusätzlichen Sensor (17) bestehende Anordnung im Wesentlichen in dem Raum zwischen den zwei Ebenen (P1, P2) befindet.

2. Gerät nach Anspruch 1, **dadurch gekennzeichnet, dass** der oben erwähnte Messer (17) ein Rogowski-Sensor ist.

3. Gerät nach Anspruch 1 oder 2, **dadurch gekennzeichnet, dass** das oben erwähnte Toroid (10) einem Stromwandler (21) zugeordnet ist, der die Phasenleiter (7, 8, 9) umgibt, so dass er bei Vorliegen eines Erdschlusses an dem sogenannten zusätzlichen Phasenleiter (8) den Verarbeitungsmitteln Leistung zuführt.

4. Gerät nach einem der vorhergehenden Ansprüche, **dadurch gekennzeichnet, dass** jeder Phasenleiter (7, 8, 9) einen sogenannten ersten Hauptteil (7a, 8a, 9a), der dazu bestimmt ist, das Toroid (10) zu durchqueren, und an jedem seiner beiden Enden einen Anschlussabschnitt (7b, 7c, 8b, 8c, 9b, 9c), der sich im Wesentlichen senkrecht zu dem Hauptteil (7a, 8a, 9a) erstreckt, aufweist, wobei sich die zwei Anschlussabschnitte jedes Phasenleiters jeweils in zwei entgegengesetzten Richtungen erstrecken.

5. Gerät nach einem der vorhergehenden Ansprüche, **dadurch gekennzeichnet, dass** der sogenannte zusätzliche Messer (17) derart ausgebildet ist, dass sich seine Achse im Wesentlichen parallel zur Achse des Toroids (10) erstreckt.

6. Gerät nach einem der Ansprüche 1 bis 4, **dadurch gekennzeichnet, dass** der sogenannte zusätzliche Phasensensor (17) derart ausgebildet ist, dass sich seine Achse im Wesentlichen senkrecht zur Achse des Toroids (10) erstreckt.

7. Gerät nach einem der vorhergehenden Ansprüche, **dadurch gekennzeichnet, dass** sich der Eingangs-Anschlussbereiche (11, 12, 13) und der Ausgangs-Anschlussbereich (14, 15, 16) ein und desselben Phasenleiters (7, 8, 9) im Wesentlichen parallel zueinander erstrecken.

8. Gerät nach einem der vorhergehenden Ansprüche, **dadurch gekennzeichnet, dass** der oder jeder der N-1 Phasenleiter (7, 8, 9) ein erstes Mal zwei Biegungen um einen rechten Winkel erfahren hat, um seine Einführung in die Öffnung des Toroids (10) zu ermöglichen, wonach der Leiter erneut zweimal in einem rechten Winkel gebogen worden ist, um in den dem Leiter zugeordneten Sensor zur Messung und Stromzuführung (4, 6) eingeführt zu werden, während der zusätzliche Phasenleiter (8) das Toroid (10) und dann den zusätzlichen Messer (17) nacheinander und direkt ohne Biegung durchquert.

9. Gerät nach einem der vorhergehenden Ansprüche, **dadurch gekennzeichnet, dass** N gleich drei ist, wobei das Gerät vom dreipoligen Typ ist.

10. Gerät nach einem der Ansprüche 1 bis 8, **dadurch gekennzeichnet, dass** N gleich vier ist, wobei das Gerät vom vierpoligen Typ ist.

11. Gerät nach einem der vorhergehenden Ansprüche, **dadurch gekennzeichnet, dass** es ein Schutzschalter ist.

## Claims

1. Differential electrical protection device intended to protect at least N electrical lines and including a switching device and a trip module intended to be connected to the switching device, said trip module including firstly a device for measuring the differential current in at least two current lines, this device for measuring the differential current including a magnetic circuit including a torus intended to surround so-called primary conductors that are respectively associated with the aforementioned current lines, and secondly current measurement and power supply sensors for each current line, respectively, said switching device including power supply means and processing means connected electrically upstream to the device for measuring the differential current and to the various current measurement and power supply sensors, and downstream to a device for actuating a mechanism for opening the contacts,
**characterized in that** it includes N-1 phase conductors (7,9), each phase conductor including, between a so-called input, or upper, connection land (11,13) and a so-called output, or lower, connection land (14,16), a portion (7a,9a) able to pass through the aforementioned torus (10) and a portion (7b,9b) able to pass through a current measurement and power supply sensor (4,6), the so-called input connection lands (11,13) being situated in a first plane (P1), and the so-called output connection lands (14,16) extending in a second plane (P2), **in that** the aforementioned power supply and measurement sensors (4,6) of the N-1 phase conductors are each positioned in the space situated between the two planes (P1 ,P2), and **in that** the device furthermore includes a so-called additional phase conductor (8) including a so-called input connection land (12) and a so-called output connection land (15), a portion (8a) able to pass through the aforementioned torus and a portion (8b) able to pass through a so-called additional measurement sensor (17) only measuring the current, this so-called additional measurement sensor (17) being of small size and being positioned directly above the torus (10) in such a way that the assembly formed by the torus (10) and the additional sensor (17) is situated substantially in the space between the two planes (P1,P2).

2. Device according to Claim 1, **characterized in that** the aforementioned measurement sensor (17) is a Rogowski sensor.

3. Device according to Claim 1 or 2, **characterized in that** the aforementioned torus (10) is associated with a current transformer (21) surrounding the phase conductors (7, 8, 9), so as to supply power to the processing means in the presence of a ground fault on the so-called additional phase conductor (8).

4. Device according to any one of the preceding claims, **characterized in that** each phase conductor (7, 8, 9) includes a so-called first main part (7a,8a,9a) intended to pass through the torus (10) and, at each of its two ends, a connecting portion (7b,7c,8b,8c,9b,9c) extending substantially perpendicular to the main part (7a,8a,9a), the two connecting portions of each phase conductor extending in two opposite directions, respectively.

5. Device according to any one of the preceding claims, **characterized in that** the so-called additional measurement sensor (17) is shaped in such a way that its axis extends substantially parallel to the axis of the torus (10).

6. Device according to any one of Claims 1 to 4, **characterized in that** the so-called additional phase sensor (17) is shaped in such a way that its axis extends substantially perpendicular to the axis of the torus (10).

7. Device according to any one of the preceding claims, **characterized in that** the two input (11, 12, 13) and output (14, 15, 16) connection lands of one and the same phase conductor (7, 8, 9) extend substantially parallel with respect to one another.

8. Device according to any one of the preceding claims, **characterized in that** the or each of the N-1 phase conductors (7, 8, 9) has initially been bent twice at a right angle so as to enable it to be inserted into the aperture of the torus (10), after which said conductor has again been bent twice at a right angle so as to be inserted into the measurement and power supply sensor (4,6) associated with said conductor, while the additional phase conductor (8) passes successively and directly through the torus (10) and then the additional measurement sensor (17) without bending.

9. Device according to any one of the preceding claims, **characterized in that** N is equal to three, the device being of three-pole type.

10. Device according to any one of Claims 1 to 8, **characterized in that** N is equal to four, the device being of four-pole type.

11. Device according to any one of the preceding claims, **characterized in that** it is a circuit breaker.
